## Europäisches Patentamt
## European Patent Office
## Office européen des brevets

(11) Veröffentlichungsnummer: **0 126 960**
**B1**

(12) # EUROPÄISCHE PATENTSCHRIFT

(45) Veröffentlichungstag der Patentschrift:
29.06.88

(21) Anmeldenummer: **84104503.2**

(22) Anmeldetag: **19.04.84**

(51) Int. Cl.⁴: **H 01 L 21/82,** H 01 L 27/10, H 01 L 29/60

(54) **Verfahren zum Herstellen von Speicherzellen mit einem ein schwebendes Gate aufweisenden MOS-Feldeffekttransistor.**

(30) Priorität: **03.05.83 DE 3316096**

(43) Veröffentlichungstag der Anmeldung:
**05.12.84 Patentblatt 84/49**

(45) Bekanntmachung des Hinweises auf die Patenterteilung:
**29.06.88 Patentblatt 88/26**

(84) Benannte Vertragsstaaten:
**AT CH DE FR GB IT LI**

(56) Entgegenhaltungen:
**EP-A-0 055 408**
**EP-A-0 112 078**
**DE-A-3 037 744**
**DE-A-3 107 543**

(73) Patentinhaber: **Siemens Aktiengesellschaft Berlin und München, Wittelsbacherplatz 2, D-8000 München 2 (DE)**

(72) Erfinder: **Klingenstein, Werner, Dr. Dipl.- Phys., Latschenweg 1, D-8011 Kirchheim (DE)**
Erfinder: **Longo, Hans- Eberhard, Dipl.- Ing., Schleissheimer Strasse 501, D-8000 München 45 (DE)**

EP 0 126 960 B1

**Beschreibung**

Die Erfindung bezieht sich auf ein Verfahren zum Herstellen von Speicherzellen mit einem ein schwebendes Gate aufweisenden MOS-Feldeffekttransistor, bei dem zunächst der für die Speicherzelle vorgesehene Teil der Oberfläche eines monokristallinen Siliciumkörpers durch thermische Oxydation mit einer einen Teil des Gateoxyds für den mit dem schwebenden Gate zu versehenden MOS-Feldeffekttransistor bildenden ersten $SiO_2$-Schicht abgedeckt und in dieser ersten $SiO_2$-Schicht an der für den Löschbereich der Speicherzelle vorgesehenen Stelle ein zur Oberfläche des Siliciumkörpers durchgehendes Fenster erzeugt wird, bei dem dann in einem weiteren thermischen Oxydationsprozeß die in dem Fenster freiliegende Oberfläche des Siliciumkörpers erneut oxydiert und gleichzeitig die noch vorhandene Oxydbedeckung des Siliciumkörpers dem Oxydationsprozeß mitunterzogen wird, bei dem dann die Oberfläche der erzeugten $SiO_2$-Schicht mit einer ersten Schicht aus polykristallinem Silicium abgedeckt und aus dieser polykristallinen Siliciumschicht das schwebende Gate hergestellt wird, bei dem nach Formung des schwebenden Gates dieses durch eine thermisch erzeugte Oxydschicht abgedeckt wird und auf dieser Oxydschicht dann eine weitere - die Grundlage für das Steuergate des das schwebende Gate enthaltenden MOS-Feldeffekttransistors bildende - weitere polykristalline Siliciumschicht aufgebracht und aus ihr das Steuergate geformt wird und bei dem schließlich durch einen unter Verwendung eines der beiden Gates als Maske durchgeführten Dotierungsprozeß, insbesondere Implantationsprozeß, die Source- und die Drainzone des mit dem schwebenden Gate versehenen MOS-Feldeffekttransistors hergestellt wird.

Ein solches Verfahren ist in DE-A-3 037 744 bzw in "Electronics", February 28, 1980, S. 113 bis 117, beschrieben.

Dort ist angegeben, daß die Aufladung bzw. Entladung des schwebenden Gates des Speichertransistors einer sog. E2-PROM-Speicherzelle über die in dem sog. Löschbereich innerhalb des genannten Fensters in der durch den ersten Oxydationsprozeß entstandenen $SiO_2$-Schicht erfolgt, so daß dieses Fenster sowohl als Löschfenster als auch als Programmierfenster für den Speichertransistor und damit für die E2-PROM-Speicherzelle dient.

Ein gattungsgemäßes Verfahren ist auch aus der EP-A-0 055 408 bekannt.

Hinsichtlich des Aufbaus einer üblichen E2-PROM-Speicherzelle ist in Anbetracht des Standes der Technik festzustellen, daß es sich hier normalerweise um eine sog. Zwei-Transistor-Speicherzelle handelt, die aus einem mit dem schwebenden Gate versehenen Speichertransistor und einem diesen mit der zugehörigen Spaltenleitung der aus solchen Zellen aufgebauten Speichermatrix verbindenden normalen MOS-Schalttransistor besteht. Der Speichertransistor liegt bei allen E2-PROM-Zellen der Speichermatrix am Bezugspotential, während die Spaltenleitung entsprechend der jeweils anzuwendenden Betriebsweise des Speicheres mit einer Betriebsspannung im Bereich von 0 bis 20 V zu beaufschlagen ist. Die beiden jeweils in Serie bezüglich ihrer Source-Drainstrecke liegenden Transistoren jeder Zelle sind bevorzugt in n-Kanal-Technik ausgebildet. Ferner sind die den einzelnen Matrixzeilen jeweils zugeordneten E2-PROM-Speicherzellen jeweils über das Gate ihres Schalttransistors mit einer der betreffenden Matrixzeile jeweils zugeordneten Auswahlleitung und das Steuergate des Speichertransistors dieser Zellen über eine parallel zu dieser Auswahlleitung verlaufende Programmier- bzw. Löschleitung verbunden. Über diese Leitung sowie über das vom Siliziumkörper gebildete Substrat wird die für die Programmierung bzw. Löschung der Speicherzelle erforderliche Programmier- bzw. Löschspannung angelegt. Dies führt zu einer Aufladung bzw. Entladung des schwebenden Gates unter Vermittlung des Dünnoxyds am Löschbereich als Medium.

Nun ist die Anzahl der an einer gegebenen E2-PROM-Speicherzelle durchführbaren Programmier- bzw. Löschprozesse begrenzt. Erfahrungsgemäß können an der einzelnen Zelle im Durchschnitt nur 20000 bis 40000 Lösch- und Programmievorgänge vorgenommen werden. Dies ist deswegen der Fall, weil im Bereich des genannten Dünnoxyds die Isolationsfestigkeit der Oxydschicht infolge der durch diese Vorgänge bedingten Belastung beeinträchtigt wird. Diese Beeinträchtigung ist dadurch bedingt, daß an der Grenze zwischen dem durch eine Polysiliciumelektrode und dem Dünnoxyd im Programmier- und Löschfensterbereich abgedeckten Halbleiterbereich ein pn-Übergang, nämlich der Übergang zwischen Substratbereich und der hochdotierten Drainzone des Speichertransistors, vorliegt. Die an diesem pn-Übergang im Bereich Dünnoxyds auftretende Durchbruchspannung ist durch das schwebende Gate beeinflußt und hängt von dessen Ladungszustand ab. Die an solchen pn-Übergängen auftretende Durchbruchsspannung führt, wenn sie erreicht oder gar überschritten wird, zur Entstehung heißer Ladungsträger in dem an das Dünnoxyd angrenzenden Halbleiterbereich, was zwangsläufig zu einer Schädigung des darüber liegenden Dünnoxyds führt. Diese Schädigung des Dünnoxyds führt zu einer erheblichen Verminderung seiner Standfestigkeit gegenüber der Beanspruchung bei Programmier- und Löschvorgängen.

Es ist Aufgabe der vorliegenden Erfindung, hier eine Abhilfe zu schaffen, so daß die Durchschnittszahl der möglichen Programmier- und Löschzyklen merklich vergrößert wird.

Hierzu ist gemäß der Erfindung vorgesehen, daß nach Erzeugung der ersten $SiO_2$-Schicht diese mit einer - zugleich das in dieser zu erzeugende Fenster zur Oberfläche des Siliciumkörpers definierenden-Implantationsmaske bedeckt und unter Begrenzung durch diese Implantationsmaske eine Ionenimplantation unter Verwendung von zu dem für die Source- und Drainzone vorgesehenen Leitungstyp führenden dotierenden Ionen in den durch das Fenster dann freizulegenden Bereich des Siliciumkörpers vorgenommen wird, und daß dann nach Erzeugung des Fensters in der ersten $SiO_2$-Schicht der Herstellungsprozeß für den MOS-Feldeffekttransistor mit dem schwebenden Gate in üblicher Weise weitergeführt wird.

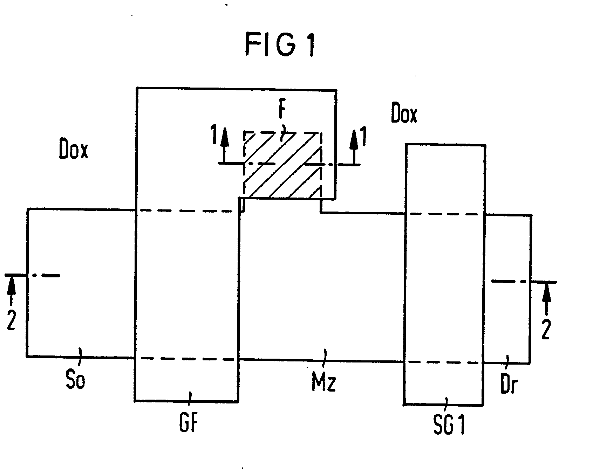

Die Erfindung wird nun anhand der Figuren 1 bis 7 näher beschrieben, in denen die einzelnen Schritte des erfindungsgemäßen Verfahrens dargestellt sind.

Das erfindungsgemäße Verfahren geht zweckmäßig von einem p-dotierten monokristallinen scheibenförmigen Siliciumkörper, dem Substrat ST, aus, dessen zu bearbeitende Oberfläche (100)-orientiert ist. Gegebenenfalls kann die zu bearbeitende Oberfläche auch die Oberfläche einer epitaktisch auf einem n-dotierten Siliciumeinkristall abgeschiedenen p-dotierten Siliciumschicht sein. Die Konzentration der insbesondere aus Bor bestehenden Dotierung des Substrats ST ist auf einen Widerstandswert von 30 - 50 Ohm.cm eingestellt.

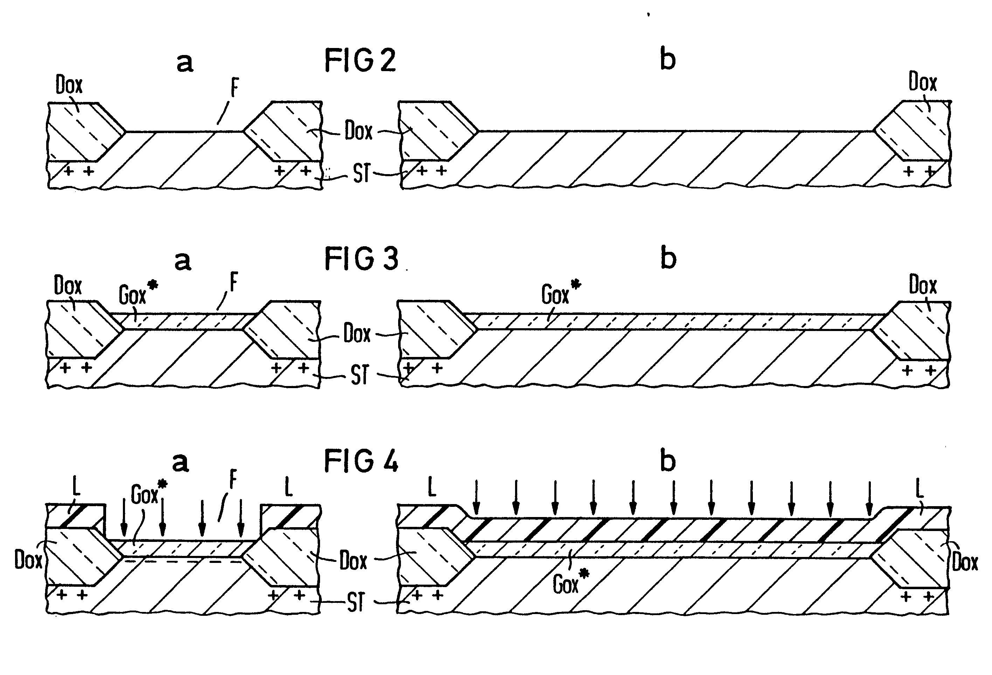

Vor der Durchführung des erfindungsgemäßen Verfahrens wird die (100)-orientierte Substratoberfläche in die den einzelnen Speicherzellen zugeteilten Bereiche durch Erzeugung des die einzelnen Bereiche rahmenförmig umgebenden Feldoxyds Dox unterteilt. Zweckmäßig wird hierzu an der Substratoberfläche zunächst eine etwa 50 nm dicke Oxydschicht insbesondere durch thermische Oxydation erzeugt und mit einer Siliciumnitridschicht von etwa 160 nm Stärke abgedeckt. Mittels Photolack-Ätztechnik werden - z. B. unter Verwendung des Plasma-Ätzverfahrens - die mit dem Feldoxyd Dox zu versehenden Stellen der Substratoberfläche freigelegt, während die von den noch zu erzeugenden Speicherzellen einzunehmenden und von dem Feldoxydrahmen Dox jeweils umgebenen Bereiche der Substratoberfläche zunächst von der 50 nm starken Oxydschicht und der als Oxydationsmaske verwendeten Siliciumnitridschicht bedeckt bleiben. An den freigelegten Stellen der Substratoberfläche wird zunächst durch Implantation von Borionen die Substratdotierung lokal erhöht. Dann wird die Erzeugung des Feldoxyds an den durch die Borimplantation vorbehandelten Stellen der Substraoberfläche vorgenommen. Die Stärke des Feldoxyds Dox wird beispielsweise auf 1,3 µm eingestellt. Schließlich wird die Nitridschicht, z. B. durch Ätzung mit heißer Phosphorsäure oder durch Plasmaätzung, entfernt. Die als Träger der aus Siliciumnitrid bestehenden Oxydationsmaske verwendete Oxydschicht kann ggf. als Grundlage für das Gateoxyd erhalten bleiben. In vielen Fällen wird man jedoch nach der Erzeugung des Feldoxyds Dox nicht nur die Nitridschicht sondern auch die sie tragende Oxydschicht von der Siliciumoberfläche entfernen, so daß man die aus Fig. 2 ersichtlichen Verhältnisse hat.

In Figur 1 ist das Layout der herzustellenden $E^2$-PROM-Zelle dargestellt. Die Beschreibung der Herstellungsprozesse erfolgt anhand der übrigen Figuren, die den jeweils erreichten Zustand längs der Schnittlinie 1 in einem Teil a und längs der Schnittlinie 2 in einem Teil b darstellen.

Dem Ausgangszustand entsprechend Fig. 2a und 2b hat man also den vom Feldoxyrahmen Dox umgebenen Bereich der p-dotierten Substratoberfläche. Die durch die genannte Borimplantation erzielte Erhöhung der Dotierung im Substrat ST ist durch " + "-Zeichen angedeutet. In dem nun folgenden ersten Oxydationsprozeß gemäß der Definition der Erfindung wird die nunmehr in den einzelnen zur Herstellung je einer Speicherzelle vorgesehenen Bereichen freiliegende Oberfläche des Substrats ST mit einer die Grundlage des Gateoxyds am Ort der beiden für die Speicherzelle vorgesehenen Transistoren bildenden ersten Oxydschicht Gox* bedeckt. Dabei wird die Stärke dieser ersten Oxydschicht Gox* derart eingestellt, daß ihre Summe mit der Stärke des für das innere des zu erzeugenden Fensters genau die für das Gateoxyd Gox am Ort der beiden die Zelle bildenden MOS-Feldeffekttransistoren ergibt. Der nunmehr vorliegende Zustand ist in Fig. 3 dargestellt.

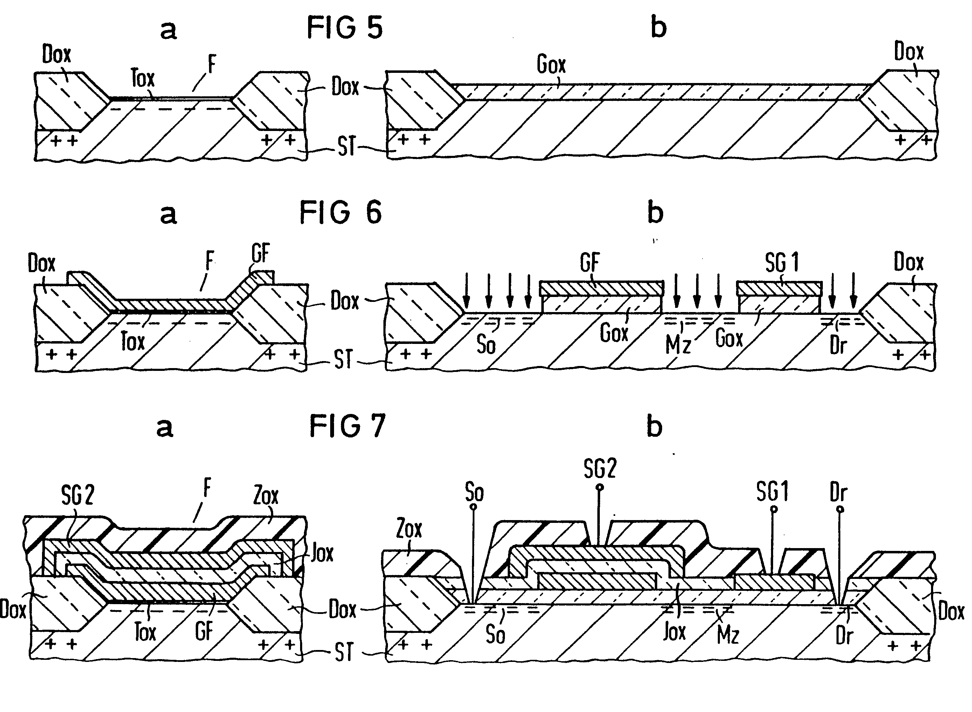

Bei dem erfindungsgemäßen Verfahren wird nun noch in üblicher Weise die für die Erzeugung des Programmier- und Löschfensters in der Oxydschicht Gox* erforderliche Photolackätzmaske L aufgebracht. Diese bedeckt die Gesamtoberfläche der Anordnung mit Ausnahme der für die Erzeugung des Programmier- und Löschfensters F vorgesehenen Stelle. Da das Fenster F dort entstehen soll, wo in der Nähe der Speichertransistor der herzustellenden Zelle beabsichtigt ist, und der hierfür vorgesehene Ort nur die Schnittlinie 1 aber nicht die Schnittlinie 2 berührt, ist in der den erreichten Zustand darstellenden Fig. 4 die Photolackschicht L im Teil 4b vollständig erhalten, während sie im Teil 4a von der Oberfläche der $SiO_2$-Schicht Gox* entfernt ist.

Zu bemerken ist weiterhin, daß für das erfindungsgemäße Verfahren die Photolackmaske L nicht nur als Ätzmaske sondern unmittelbar vorher auch als Implantationsmaske eingesetzt wird, was bei der Einstellung der Stärke der Photolackschicht L zu berücksichtigen ist. Bei dem erfindungsgemäßen Verfahren wird somit nach dem Aufbringen der Photolackschicht L und deren Entfernung durch Belichten und Entwickeln von der für das Fenster F vorgesehenen Stelle der ersten Oxydschicht Gox* die Implantation mit Ionen eines dotierenden Elements vorgenommen, das den für die Source- und Drainzone der beiden Transistoren der Speicherzelle vorgesehenen Leitungstyp erzeugt. Im vorliegenden Fall müssen demnach Donatorionen, insbesondere Phosphorionen oder Arsenionen verwendet werden. Die Stärke der Photolackmaske L und die Implantationsenergie werden so aufeinander abgestimmt, daß die zu implantierenden Zonen an der von der Photolackschicht freigelegten Stelle (Fig. 4a) die erste Oxydschicht Gox* durchdringen und zu einer Umdotierung des an die Oxydschicht unmittelbar angrenzenden Bereiches des Substrats ST führen, während an den von der Lackschicht L bedeckten Stellen der Oxydschicht Gox* und auch des Dickoxyds Dox ein Vordringen der Implantionsionen in das Substrat unterbunden ist. Die erreichte Umdotierung ist noch in Fig. 4a durch die Zeichen "-" angedeutet.

Das Ziel dieser Umdotierung im Bereich des noch zu erzeugenden Programmier- und Löschfensters F ist, daß dieser Bereich mit der noch zu erzeugenden Drainzone des Speichertransistors eine gemeinsame Zone vom Leitungstyp der Drainzone bildet und damit ein pn-Übergang unterhalb des Fensters F innerhalb des noch zu erzeugenden Dünnoxydbereichs ausgeschlossen ist. Um dies auf jeden Fall auch mit Rücksicht auf die oben erwähnte Borimplantation unterhalb des Feldoxyds Dox sicherzustellen wird bevorzugt die am Ort des nunmehr zu erzeugenden Fensters F vorher durchgeführte Donatorimplantation derart bemessen, daß die aufgrund der Umdotierung erreichte effektive Dotierungskonzentration am Ort des Fensters F etwa der doppelten Akzeptorkonzentration unterhalb des Feldoxyds Dox entspricht.

Der zur Erzeugung des Fensters F unter Verwendung der unveränderten Photolack-Implantationsmaske L als Ätzmaske und unter Verwendung eines für SiO₂ spezifischen Ätzmittels, wie verdünnten Flußsäure, durchgeführte Ätzprozeß ist allgemein üblich und bedarf deshalb keiner weiteren Beschreibung. Anschließend wird die Photolackmaske L von der Oberfläche der ersten Oxydschicht Gox* entfernt und die erhaltene Anordnung einem weiteren thermischen Oxydationsprozeß entsprechend den in DE-A-3 037 744 dargelegten Gesichtspunkten unterworfen.

Aufgrund des zuletzt genannten Oxydationsvorgangs wird an der im Fenster F freiliegenden Oberfläche des Siliciumsubstrats ST eine sehr dünne SiO₂-Schicht Tox (= Tunnel-Oxyd) gebildet, deren Stärke in üblicher Weise, d. h. auf den Bereich von 10 bis 15 nm, eingestellt wird. Gleichzeitig mit der Entstehung der Tunneloxydschicht Tox im Fenster F erfolgt eine Verstärkung der ersten Oxydschicht Gos* auf den für das Gateoxyd Gox der beiden Transistoren der Speicherzelle erforderlichen Wert, der merklich über der für das Tunneloxyd im Fenster F vorgesehenen Stärke liegt (z. B. 90 - 110 nm). Zu bemerken ist, daß man zweckmäßig die Erzeugung der den Oxydschicht Tox im Fenster F bei einer Temperatur von etwa 850° C durchführt.

Der nunmehr vorliegende Zustand der herzustellenden Speicherzelle ist in Fig. 5a und 5b dargestellt. Es schließt sich nun die in üblicher Weise vorzunehmende Abscheidung der ersten polykristallinen Siliciumschicht an, die ganzflächig aufgebracht wird und dann mittels der üblichen maskierten Ätztechnik auf die das schwebende Gate GF des Speichertransistors und das Steuergate SG1 des Schalttransistors bildende Bereiche beschränkt wird. Dabei ist zu bemerken, daß das Tunneloxyd Tox im Fenster F vollständig mit dem schwebenden Gate GF abgedeckt wird. Der erhaltene Zustand ist aus Fig. 6a bzw. 6b ersichtlich. Zu bemerken ist noch, daß die Dotierung der ersten Polysiliciumschicht - insbesondere unter Verwendung von Phosphor als Dotierungsmaterial - entweder gleichzeitig mit der Abscheidung oder unmittelbar danach und zwar zweckmäßig noch vor dem genannten Ätzprozeß - vorteilhafterweise vorgenommen wird.

Anschließend an den aus Fig. 6a und 6b ersichtlichen Zustand erfolgt entsprechend der eingangs angegebenen Definition ein weiterer Oxydationsschritt, der zur Entstehung einer Isolierschicht Jox an der Oberfläche der noch vorhandenen Teile GF und SG1 der ersten polykristallinen Siliciumschicht führt. Die unmittelbar nach diesem Oxydationsprozeß vorliegende Anordnung wird mit einer zweiten polykristallinen Siliciumschicht, die ebenfalls mit Phosphor dotiert ist, abgedeckt, was (ebenso wie die Abscheidung der ersten polykristallinen Siliciumschicht) durch pyrolythische Zersetzung von PH₃-haltigem verdünntem SiH₄ geschehen kann. Als nächster Schritt erfolgt die Formung des Steuergates SG2 des Speichertransistors der herzustellenden E²-PROM-Zelle durch maskiertes Ätzen der zweiten polykristallinen Siliciumschicht, was wiederum unter Anwendung der üblichen Photolack-Ätztechnik geschieht.

Zu bemerken ist dabei, daß die für die Aufnehme des die Source-Zone sowie die Drainzone bildenden Dotierungsstoffes, insbesondere von Arsen, dienenden Stellen der Oberfläche des Substrats ST zwar von der Gateoxydschicht Gox aber von keiner Schicht aus polykristallinem Silicium, also weder von den aus diesen hergestellten Gates GF bzw. SG1 bzw. SG2, mit abgedeckt sind. Die Source- und Drainzonen der die Speicherzelle bildenden Transistoren können also in einem gemeinsamen Implantationsprozeß, z. B. unter Verwendung von Arsenionen und unter Verwendung der erhaltenen Gates GF, SG1 und SG2 sowie des Feldoxyds Dox als Implantationsmaske hergestellt werden, wenn man die Implantationsenergie so auf die Dicke der Oxydschichten Dox, Gox und der einzelnen nochvorhandenen polykristallinen Siliciumschichtteile GF, SG1 und SG2 abstimmt, daß die Implantationsionen zwar durch die Oxydschicht Gox aber nicht durch die Oxydschicht Dox bzw. durch die Polysilgates GF, SG1, SG2 und die sie tragenden Stellen der Gateoxyschicht Gox in das darunterliegende einkristalline Siliciumsubstrat eindringen können. Die Implantation erfolgt zweckmäßig mit einem senkrecht zu der Oberfläche des zu behandelnden Substrats ST gerichteten Ionenstrahl.

Schließlich wird die Gesamtanordnung mit einer äußeren Isolationsschicht Zox, die insbesondere aus durch Aufsputtern aufgebrachtem $SiO_2$ besteht abgedeckt und in ihr durch lokalisiertes Ätzen die zum Steuergate SG2 des Speichertransistors führende Kontaktöffnung erzeugt. Eine weitere Kontaktöffnung durch die äußere Isolierschicht Zox sowie durch die an der Außenfläche des Steuergates SG1 des Schalttransistors erzeugte Oxydschicht Jox geht zu dem dotierten Polysilgate SG1 des Schalttransistors. Je ein weiteres Kontaktfenster für den Sourceanschluß und den Drainanschluß ist sowohl durch die äußere Isolierschicht Zox als auch durch das Isolationsoxyd Jox zum Substrat ST an der von der Sourcezone bzw. Drainzone eingenommenen Stelle zu führen. Die in diese Kontaktöffnungen einzubringenden Anschlüsse können z. B. aus Aluminium bestehen.

Der erhaltene Endzustand ist in Fig. 7a am Ort des Tunnelfensters F und längs der Schnittlinie 2 in Fig. 7b dargestellt.

Hierzu ist noch festzustellen, daß die Drainzone des Schalttransistors mit Dr, die Sourcezone des Speichertransistors mit so und die beiden Transistoren gemeinsame stromführende Zone (= Source für den Schalttransistor und Drain für den Speichertransistor) mit MZ bezeichnet ist.

Zu erwähnen ist dabei, daß man die Herstellung der Source- und Drainzonen der beiden die Speicherzellen bildenden Transistoren auch unmittelbar nach der Formung des schwebenden Gates GF und des Steuergates SG1 des Schalttransistors aus der ersten Polysiliciumschicht herstellen kann. Hierzu wird das Gateoxyd Gox an den für Source und Drain vorgesehenen Stellen des Substrats ST durch lokalisiertes Ätzen entfernt und dann die Source- und Draindotierung durch einen vorwiegend mit Arsenionen und/oder Phosphorionen durchgeführten Implantationsprozeß erzeugt. Als Implantationsmaske dient dabei die für die lokalisierte Entfernung des Gateoxyds Gox am Ort der zu erzeugenden Source- bzw. Drainzone verwendete Photolack-Ätzmaske oder ohne Lackmaske das strukturierte polykristalline Silicium GF bzw. SG1 selbst. Dies ist in Fig. 6b berücksichtigt.

Anschließend an die Herstellung von Source und Drain der beiden die Speicherzelle bildenden Transistoren erfolgt in diesem Falle eine Oberflächenoxydation Jox an der Außenseite von GF und SG1 sowie auf den hochdotierten Substratgebieten (Source- und Drain). Darauf erfolgt die Abscheidung der zweiten polykristallinen Siliciumschicht und deren Verarbeitung zum Steuergate SG2 des Speichertransistors.

Die aufgrund des erfindungsgemäßen Verfahrens entstandenen Speichertransistoren weisen eine erheblich vergrößerte Zahl hinsichtlich der möglichen Programmiervorgänge und Löschvorgänge auf. Die Zahl der möglichen Programmier- und Löschvorgänge beträgt dann mehr als 250 000.

**Patentansprüche**

1. Verfahren zum Herstellen von Speicherzellen mit einem ein schwebendes Gate aufweisenden MOS-Feldeffekttransistor, bei dem zunächst der für die Speicherzelle vorgesehene Teil der Oberfläche eines monokristallinen Siliciumkörpers durch thermische Oxydation mit einer einen Teil des Gateoxyds für den mit dem schwebenden Gate zu versehen den MOS-Feldeffekttransistor bildenden ersten $SiO_2$-Schicht abgedeckt und in dieser ersten $SiO_2$-Schicht an der für den Löschbereich der Speicherzelle vorgesehenen Stelle ein zur Oberfläche des Siliciumkörpers durchgehendes Fenster erzeugt wird, bei dem dann in einem weiteren thermischen Oxydationsprozeß die in dem Fenster freiliegende Oberfläche des Siliciumkörpers erneut oxydiert und gleichzeitig die noch vorhandene Oxydbedeckung des Siliciumkörpers dem Oxydationsprozeß mit unterzogen wird, bei dem dann die Oberfläche der an der Oberfläche des Siliciumkörpers vorhandenen Oxydbedeckungen mit einer ersten Schicht aus Polykristallinem Silicium abgedeckt und aus dieser polykristallinen Siliciumschicht das schwebende Gate hergestellt wird, bei dem nach Formung des schwebenden Gates dieses durch eine thermisch erzeugte Oxydschicht abgedeckt wird und auf dieser Oxydschicht dann eine weitere - die Grundlage für das Steuergate des das schwebende Gate enthalten den MOS-Feldeffekttransistors bildende - weitere polykristline Siliciumschicht aufgebrach und aus ihr das Steuergate geformt wird, und bei dem schließlich durch einen unter Verwendung eines der beiden Gates als Maske durchgeführten Dotierungsprozeß, insbesondere Implantationsprozeß, die Source- und die Drainzone des mit dem schwebenden Gate versehenen MOS-Feldeffekttransistors hergestellt wird, bei dem nach Erzeugung der ersten $SiO_2$-Schicht (Gox*) diese mit einer - zugleich das in dieser zu erzeugende Fenster (F) zur Oberfläche des Siliciumkörpers (ST) definierenden - Implantationsmaske (L) bedeckt und unter Begrenzung durch diese Implantationsmaske (L) eine Ionenimplantation unter Verwendung von zu dem für die Source- und Drainzone vorgesehenen Leitungstyp führenden dotierenden Ionen in den durch das Fenster (F) dann freizulegenden Bereich des Siliciumkörpers (ST) vorgenommen wird, bei dem dann nach Erzeugung des Fensters (F) in der ersten $SiO_2$-Schicht (Gox*) der Herstellungsprozeß für den MOS-Feldeffekttransistor mit dem schwebenden Gate (GF) in üblicher Weise weitergeführt wird, bei dem das der herzustellenden Speicherzelle jeweils zugeordnete Gebiet an der Oberfläche des z. B. p-dotierten Siliciumkörpers (ST) mit einer dickeren SiO₂-Schicht (Dox) umrahmt wird (LOCOS-Verfahren) bevor die erste SiO₂-Schicht (Gox*) am Ort der zu erzeugenden Speicherzelle hergestellt wird und bei dem die dickere SiO₂-Schicht (Dox) auf einem im Vergleich zu der für die Speicherzelle vorgesehenen Oberfläche des Siliciumkörpers (ST) höher dotierten Oberflächenteil erzeugt wird, dadurch gekennzeichnet,

- daß eine Umdotierung durchgeführt wird im Bereich des Fensters (F), das in der ersten SiO₂-Schicht (Gox*) zu erzeugen ist, sodaß der Fensterbereich mit der Drainzone des Speichertransistors eine gemeinsame Zone bildet vom Leitungstyp der Drainzone,

- daß die Umdotierung mittels Implantation erfolgt,

- daß die Umdotierung unmittelbar nach Erzeugung der ersten SiO₂-Schicht (Gox) durchgeführt wird und

- daß die Implantation derart eingestellt wird, daß die aufgrund dieser Implantation entstehende umdotierte Zone innerhalb des Fensters (F) eine effektive Dotierungskonzentration erhält, die etwa doppelt so groß wie die effektive Dotierung unterhalb des dickeren Oxyds (Dox) ist.

2. Verfahren nach Anspruch 1, dadurch gekennzeichnet, daß der unmittelbar nach der Erzeugung des Fensters (F) vorzunehmende thermische Oxydationsprozeß bei etwa 850° C vorgenommen wird.

**Claims**

1. A method for the production of storage cells comprising a MOS field effect transistor which has a floating gate, wherein firstly that part of the surface of a monocrystalline silicon body provided for the storage cell is covered by thermal oxidation with a first SiO₂-layer which forms a part of the gate oxide layer for the MOS field effect transistor which is to be provided with the floating gate, and in this first SiO₂-layer, at the location provided for the erasing zone of the storage cell, a window is formed which extends to the surface of the silicon body, wherein, in a further thermal oxidation process, the surface of the silicon body which is exposed in the window is then re-oxidised and simultaneously the still present oxide covering of the silicon body is additionally subjected to the oxidation process, wherein the surface of the oxide coatings present at the surface of the silicon body are covered with a first layer of polycrystalline silicon and from this polycrystalline silicon layer the floating gate is formed, wherein, following the formation of the floating gate, the latter is covered with a thermally produced oxide layer and to this oxide layer there is then applied a further polycrystalline silicon layer, which forms the basis for the control gate of the MOS field effect transistor which contains the floating gate, and from which the control gate is formed, and wherein finally by a doping process, in particular an implantation process, which is carried out using one of the two gates as a mask, the source- and drain zones of the MOS field effect transistor provided with the floating gate are formed, wherein, following the formation of the first SiO₂-layer (Gox*), the latter is covered with an implantation mask (L), which simultaneously defines the window (F) to be produced therein down to the surface of the silicon body (ST), and, limited by this implantation mask (L), an ion implantation into that region of the silicon body (ST) which is to be exposed through the window (F) is carried out using doping ions which lead to the conductivity type provided for the source and drain zones, wherein, after the formation of the window (F) in the first SiO₂-layer (Gox*), the production process for the MOS field effect transistor with the floating gate (GF) is continued in the usual way, wherein that region of the surface of the, for example, p-doped silicon body (ST) which is in each case assigned to the storage cell to be produced, is framed by a thicker SiO₂-layer (Dox) (LOCOS-process) before the first SiO₂-layer (Gox*) is formed at the location of the storage cell to be produced, and where the thicker SiO₂-layer (Dox) is produced on a part of the surface which is doped to a higher level than the surface of the silicon body (ST) provided for the storage cell, characterised in that

- a redoping is carried out in the region of the window (F) which is to be formed in the first SiO₂-layer (Gox*), so that the window region together with the drain zone of the storage transistor forms a common zone which has the conductivity type of the drain zone,

- that the redoping is carried out by means of implantation,

- that the redoping is carried out immediately following the formation of the first SiO₂-layer (Gox*), and

- that the implantation is arranged to be such that the redoped zone within the window (F) which is formed as a result of this implantation acquires an effective doping concentration which is approximately double the effective doping below the thicker oxide layer (Dox).

2. A method as claimed in Claim 1, characterised in that the thermal oxidation process which is to be carried out directly after the formation of the window (F) is carried out at approximately 850° C.

**Revendications**

1. Procédé pour fabriquer des cellules de mémoire comportant un transistor à effet de champ MOS possédant une grille flottante, et selon lequel on recouvre tout d'abord la partie, prévue pour la cellule de mémoire, de la surface d'un corps en silicium monocristallin, par oxydation thermique, avec une première couche de SiO$_2$ constituant une partie de l'oxyde de grille prévu pour le transistor a effet de champ MOS devant être pourvu de la grille flottante, et on réalise, dans cette première couche de SiO$_2$, à l'emplacement prévu pour la zone d'effacement de la cellule de mémoire, une fenêtre traversant la couche jusqu'à la surface du corps en silicium, et selon lequel ensuite, lors d'une opération supplémentaire d'oxydation thermique, on oxyde à nouveau la surface, qui est à nu dans la fenêtre, du corps en silicium et on soumet simultanément le revêtement d'oxyde, encore présent, du corps en silicium à l'opération d'oxydation, et selon lequel ensuite on recouvre la surface des revêtements d'oxyde, qui sont présents au niveau de la surface du corps en silicium, avec une première couche de silicium polycristallin et on forme la grille flottante à partir de cette couche de silicium polycristallin, et selon lequel, après formation de la grille flot tante, on recouvre cette dernière avec une couche d'oxyde produite par voie thermique et on dépose ensuite, sur cette couche d'oxyde, une couche supplémentaire de silicium polycristallin - qui constitue la couche de base pour la grille de commande du transistor à effet de champ nos contenant la grille flottante - et on forme à partir de cette couche la grille de commande, et selon lequel enfin, on forme, au moyen d'une opération de dopage et notamment d'une opération d'implantation, exécutée moyennant l'utilisation de l'une des deux grilles en tant que masque, la zone de source et la zone de drain du transistor à effet de champ MOS muni de la grille flottante, et selon lequel, après formation de la première couche de SiO$_2$ (Gox*), on recouvre cette dernière avec un masque d'implantation (L) - qui définit simultanément la fenêtre (F), qui doit être produite dans cette couche et s'étend jusqu'à la surface du corps en silicium (ST) - et, on met en oeuvre, avec une limitation produite par ce masque d'implantation (L), une implantation ionique moyennant l'utilisation d'ions de dopage, qui fournissent le type de conductivité prévu pour la zone de source et la zone de drain, dans la région du corps en silicium (ST), qui doit être ensuite dégagée à travers la fenêtre (F), et selon lequel après l'aménagement de la fenêtre (F) dans la première couche de SiO$_2$ (Gox*), on poursuit de façon usuelle le processus de fabrication pour le transistor à effet de champ MOS muni de la grille flottant te (GF), et selon lequel on entoure la région, qui est associée respectivement à la cellule de mémoire devant être fabriquée et se situe au niveau de la surface du corps en silicium (ST) par exemple dopée du type p, par une couche plus épaisse de SiO$_2$ (Dox) (procédé LOCOS) avant de fabriquer la première couche de SiO$_2$ (Gox*) à l'endroit de la cellule de mémoire devant être fabriquée, et selon lequel on forme la couche plus épaisse de SiO$_2$ (Dox) sur un élément de surface plus fortement dopé que la surface, prévue pour la cellule de mémoire, du corps en silicium (ST), caractérisé par le fait

- qu'on réalise une modification du dopage dans la région de la fenêtre (F), qui doit être ménagée dans la première couche de SiO$_2$ (Gox*), de sorte que la région de la fenêtre forme, conjointement avec la zone de drain du transistor de mémoire, une zone commune possédant le type de conductivité de la zone de drain,

- que la modification du dopage s'effectue au moyen d'une implantation,

- que la modification du dopage est exécutée aussitôt après la production de la première couche de SiO$_2$ (Gox*), et

- que l'implantation est réglée de telle sorte que la zone, dont le dopage est modifié et qui apparaît par suite de cette implantation, à l'intérieur de la fenêtre (F), reçoit une concentration effective de dopage qui est égale approximativement au double du dopage effectif au-dessous de l'oxyde plus épais (Dox).

2. Procédé suivant la revendication 1, caractérisé par le fait que l'opération d'oxydation thermique, qui doit être réalisée aussitôt après l'aménagement de la fenêtre (F), est réalisée à environ 850° C.

# FIG 1

## FIG 2

a

b

## FIG 3

a

b

## FIG 4

a

b

0 126 960

FIG 5

a

Dox
Tox
F
Gox
Dox
ST
++
+ +
++
+ +

b

FIG 6

a

Dox
F
GF
Dox
Tox
ST
++
+ +

b

GF
SG1
Dox
Dox
So
Gox
Mz
Gox
Dr
ST
++
+ +

FIG 7

a

SG2
F
Zox
Jox
Dox
Tox
GF
Dox
ST
++
+ +

b

SG2
So
SG1
Dr
Zox
So
Jox
Mz
Dr
Dox
Dox
++
+ +

0 126 960